# EUROPÄISCHE PATENTSCHRIFT

(11) **EP 0 342 390 B1**
(45) Veröffentlichungstag und Bekanntmachung des Hinweises auf die Patenterteilung: **17.02.1993**
(21) Anmeldenummer: 89107405.6
(22) Anmeldetag: 24.04.1989
(51) Int. Cl.: H05K 5/00, H03H 9/05

(54) **Gehäuse für elektrische Bauelemente, Bauelementegruppen oder integrierte Schaltungen**
Casing for electric components, packages or integrated circuits
Boîtier pour composants électriques, groupes de composants ou circuits intégrés

(30) Priorität: 17.05.1988 DE 3816790
(43) Veröffentlichungstag der Anmeldung: 23.11.1989
(73) Patentinhaber: SIEMENS AKTIENGESELLSCHAFT, 80333 München (DE)
(72) Erfinder: Jung, Albert, Ing. grad., D-8028 Taufkirchen (DE)

(56) Entgegenhaltungen:
- EP-A- 0 036 671
- DE-A- 2 609 884
- DE-A- 2 610 172
- DE-A- 2 618 492
- PATENT ABSTRACTS OF JAPAN vol. 9, no. 298 (E-361)(2021) 26 November 1985, & JP-60 136247 (TOSHIBA K.K.) 19 Juli 1985

## Beschreibung

Die Erfindung betrifft ein Gehäuse für elektrische Bauelemente, Bauelementegruppen oder integrierte Schaltungen, insbesondere für ein elektrisches Oberflächenwellenfilter, deren elektrische und gegebenenfalls mechanische Anschlußelemente durch den zwischen den zueinander gekehrten Randflächen des Gehäusebechers und Gehäusedeckels gebildeten Spalt herausgeführt sind, wobei der Spalt insbesondere auch im Durchführungsbereich der Anschlußelemente mittels Kunstharzverguß hermetisch dicht geschlossen ist.

Dieses Gehäuse eignet sich für passive und aktive elektrische Bauelemente (Widerstände, Kondensatoren, Induktivitäten, Relais, Dioden, Transistoren), Bauelementegruppen, d. h. auf einer Platine aufgetragene, miteinander verschaltete passive und/oder aktive elektrische Bauelemente, und für integrierte Schaltungen. Ausgezeichnet geeignet ist dieses Gehäuse für die hermetisch dichte Unterbringung elektrischer Oberflächenwellenfilter, die üblich aus einem zu Oberflächenwellen anregbaren Substrat bestehen, das mit entsprechenden Ein- und Ausgangswandlern belegt ist.
Oberflächenwellenfilter der geschilderten Art sind in der Zeitschrift "Siemens Components" 18 (1980), Heft 1, Seiten 44 und 45 beschrieben, dort jedoch nur hinsichtlich ihrer Funktionen, nicht aber hinsichtlich der konstruktiven Details des Gehäuses.

Integrierte Schaltungen, z. B. Operationsverstärker, sind in dem Buch der Firma Siemens: "Bauelemente, Technische Erläuterungen und Kenndaten für Studierende", 2. Auflage, 1977, Seite 186 erwähnt.

Allen diesen elektrischen Bauelementen, Bauelementegruppen und integrierten Schaltungen ist gemeinsam, daß sie auf einen Träger, üblicherweise eine sog. "Trägerspinne" aufgebracht sind, der in aller Regel aus Metallblech besteht und bereits die äußeren, für die mechanische und elektrische Verbindung mit einer gedruckten Schaltung dienenden Anschlußteile aufweist, die durch das Gehäuseinnere nach außen geführt sind. Beim Zusammenbau werden die äußeren Anschlußteile entweder in der Trägerebene belassen oder senkrecht zu dieser abgebogen.

Integrierte Schaltungen und Halbleiterbauelemente dieser Art werden i. a. in Spritzformen mit einer Umhüllung versehen. Es kommt jedoch häufig vor, daß das elektrische Bauelement oder die integrierte Schaltung in einem mitunter sogar mit Inertgas gefüllten Hohlraum des Gehäuses untegebracht ist.

Gemäß DE-OS 2609884 ist ein Filter in einem Gehäuse untergebracht, das aus einem Becher- und einem Deckelteil besteht. Die Anschlußteile für den äußeren Anschluß sind dabei entweder im Deckelteil fest angebracht oder um diesen herumgeführt, während der Becherteil über die Elektrodenanordungen aufgebracht ist und der Deckelteil das piezoelektrisch aktive Element des Filters darstellt. Der Becherteil, dort als Schutzkappe bezeichnet, ist mit seiner Randfläche mit dem Randteil der die Elektroden tragenden Fläche des piezoelektrischen Substrates verbunden, z. B. verklebt. Die Montage dieses bekannten Wellenfilters ist aufwendig und schlecht automatisierbar, weshalb dieses Filter für die Massenfertigung ungeeignet ist. Es kommt hinzu, daß die Verbindung zwischen Schutzkappe und piezoelektrischem Substrat nicht frei von Durchlässen für atmosphärische Einflüsse wie z. B. Feuchtigkeit, Abgase usw. ist.

In der DE-AS 2610172 ist ein Oberflächenwellenfilter beschrieben bei welchem das aktive Filterteil in einem Gehäuse mit einer rechteckförmigen Bodenwand, einer rechteckförmigen Deckelwand und zwei Paaren einander gegenüberliegender Seitenwände untergebracht ist, und bei welchem sich das aktive Filterteil parallel zur Deckelwand und zur Bodenwand erstreckt, und bei welchem hinsichtlich der baulichen Ausbildung der Halterung für das Filterteil bzw. dessen Substrat davon ausgegangen ist, daß alle nutzbaren elektroakustischen Vorgänge, auf deren ungestörten Ablauf bedacht zu nehmen ist, auf dem Substrat innerhalb der Wandler und auf der Substratfläche zwischen den Wandlern vor sich gehen, wofür vorgeschlagen wird, daß im Inneren des Gehäuses dem Substrat zwei Abstützungen aus synthetischem oder natürlichem Kautschuk, vorzugsweise aus Silikon-Kautschuk zugeordnet sind, von welchen die eine Abstützung am Substrat zwischen dem Eingangswandler und der diesem Wandler benachbarten Stirnwand des Substrats angeordnet ist, während die zweite Abstützung sich zwischen dem Ausgangswandler und der diesem Wandler benachbarten Stirnwand des Substrats befindet. Die nach außen führenden Anschlußstifte sind in der Bodenwand (Deckelteil) fest angeordnet. Der Deckelteil ist samt dem aktiven Filterteil in den Becherteil derart eingesetzt, daß ein Hohlraum verbleibt. Nach beendetem Zusammenbau des Filters wird eine erheblich Kunstharzmenge auf die Außenfläche des Deckelteils aufgetragen, um den Innenraum des Gehäuses hermetisch abzudichten, wobei vor dem Auftrag des Kunstharzes gegebenenfalls Inertgas in das Gehäuseinnere eingeleitet wird.

Durch die DE-PS DE 3011730 (die der EP-A-0036671 entspricht) ist schließlich ein Gehäuse für die eingangs erwähnten elektrischen Bauelemente, Bauelementegruppen oder integrierten Schaltungen bekannt, bei dem der Becher- bzw. Schalenteil in seinen einander gegenüberliegenden Seitenwänden Ausnehmungen, die den rechtwinklig abgebogenen Anschlußteilen des elektrischen Bauelements angepaßt sind, und ferner einen abgesetzten Teil aufweist, der zusammen mit einem Steg, der auf dem Deckelteil nach außen gerichtet vorhanden ist, eine umlaufende Rinne bildet, die zu ihrem hermetisch dichten Verschluß mit Kunstharzverguß gefüllt ist. Dieses Gehäuse ermöglicht eine weitgehend automatisierbare Montage, indem das einzusetzende Bauelement, die Bauelementegruppe oder die integrierte Schaltung durch bestimmte Anordnungen in ihrer Lage festgehalten werden werden und indem dafür gesorgt wird, daß eine gewisse Abdichtung bereits ohne Kunstharzverguß eintritt, die beim weiteren Gang in der Fertigstellung das Eindringen des Kunstharzes in den Hohlraum in der Flüssigphase des Harzes verhindert. Bei allen bekannten, in ein vorzugsweise aus Kunststoff gegebenenfalls jedoch auch aus Metall bestehendes Gehäuse eingebauten elektrischen Bauelementen und dgl. tritt die Schwierigkeit auf, daß die hermetische Abdichtung des Gehäuses gegen störende Umwelteinflüsse, z. B. Feuchtigkeit, nur unzureichend und auch nicht für lange Zeiträume wirkt. So schrumpft bei einigen der vorstehend genannten Gehäuse die verwendete Kunstharzschicht und erhält Risse. Zum Teil tritt diese Rißbildung schon kurz nach der Fertigstellung auf. Zu einem nicht unerheblichen Teil treten aber auch beim abschließenden Auflöten der Anschlußelemente z. B. auf gedruckte Leiterplatten Lecks in den Bereichen der Vergußmasse auf, in denen die Anschlußelemente hindurchgeführt sind, was üblicherweise im Spaltbereich zwischen Gehäusedeckel und Gehäusebecher erfolgt. Ursache für diese Lecks ist dabei im wesentlichen die durch das flüssige Lot bedingte hohe termische Beanspruchung der zunächst noch adhäsiven Verbindung zwischen den Anschlußelementen und dem Kunstharzverguß. Im übrigen treten bei den vorstehend abgehandelten zweiteiligen Gehäusen auch aufgrund der verhältnismäßig großen Spaltbreite zwischen Gehäusedeckel und Gehäusebecher, die es zu vergießen gilt, erhebliche Vergußprobleme auf, insbesondere versickert bis zur vollständigen Schließung der Spalt- und Deckeloberfläche ein nicht unerheblicher Teil des Vergußharzes ungenutzt im Gehäuseinneren.

Der vorliegenden Erfindung liegt die Aufgabe zugrunde, ein Gehäuse der eingangs genannten Art sowie ein Verfahren zum hermetisch dichten Verschluß eines derartigen Gehäuses zu schaffen, das die vorstehend aufgezeigten sämtlichen Nachteile, so auch die beim Löten auftretenden Probleme behebt und zusätzlich eine automatisierte Fertigung gewährleistet.

Bei einem Gehäuse mit durch einen Gehäusedeckel geschlossenem Gehäusebecher zur Aufnahme elektrischer Bauelemente, Bauelementegruppen oder integrierter Schaltungen und insbesondere von Oberflächenwellenfiltern, deren elektrische und ggf. mechanische Anschlußelemente durch den zwischen den zueinandergekehrten Randflächen des Gehäusebodens und Gehäusedeckels gebildeten Spalt herausgeführt sind, sieht die Erfindung zur Lösung der vorstehend aufgezeigten Aufgabe vor, daß der Spalt mittels Kunstharzverguß und zumindest in den Bereichen der Anschlußelemente, also in den vorwiegend leckgefährdeten Spaltbereichen zusätzlich mittels Schmelzkleber im Spalt geschlossen ist.

Die vorgeschlagene Lösung nützt die Eigenschaft des Schmelzklebers, bei entsprechender Erwärmung wiederholt aufzuschmelzen und in kleine Lecks einzudrigen und diese abzudichten, in bestmöglicher Weise aus. Lecks, insbesondere im Durchführungsbereich der Anschlußelemente durch den Spalt zwischen Gehäusebecher und Gehäusedeckel, wie sie ansonsten bei hoher Temperaturbelastung der Anschlußelemente durch Löten auftreten, werden so vermieden.

Der Schmelzkleber wird bevorzugt über die gesamte Länge nicht notwendigerweise jedoch gesamte Tiefe des Spalts zwischen Gehäusedeckel und Gehäusebecher aufgebracht und die nach außen gekehrte Spalt-und üblicherweise die gesamte äußere Gehäusedeckelfläche mit Vergußmasse, insbesondere Epoxidharz bedeckt. Hierdurch, d. h. durch die Verteilung des Schmelzklebers über die gesamte Länge des Spalts, wird ein Eindringen der Verguß-masse in das Gehäuseinnere unterbunden.

Das erfindungsgemäße, automatisierbare Verfahren zum hermetisch dichten Verschluß des Gehäusebechers mit dem Gehäusedeckel sieht vor, daß zumindest die zu den Anschlußelementen gekehrte spaltbildende Fläche des Gehäusedeckels und/oder Gehäusebechers mit Schmelzkleber bedeckt, der Gehäusedeckel in den Gehäusebecher eingesetzt und anschließend der Schmelzkleber insbesondere im Vakuum geschmolzen wird, wonach die Vergußmasse, bevorzugt Epoxidharz, auf die nach außen gekehrte Spalt- und Gehäusedeckelfläche aufgetragen und ausgehärtet wird. Die Durchführung dieses Verfahrens wird erheblich erleichtert, wenn ein Gehäusedeckel mit beim Schmelzen des Schmelzklebers zunächst offener Entlüftungsbohrung verwendet wird, die erst beim abschließenden Verguß, z. B. mittels Epoxidharz geschlossen wird.

Der Schmelzkleber, wird zunächst bei einer unterhalb seines Schmelzpunktes liegenden Temperatur auf zum Gehäusbecher gekehrte Randflächen des Gehäusedeckels aufgetragen, insbesondere aufgespritzt, wobei zur sicheren Haftung des erst im späteren Verfahrenverlauf auf höhere Temperatur erwärmten Schmelzklebers auf dem Gehäusedeckel, in dessen Randflächen Bohrungen vorgesehen sind, in denen sich der Schmelzkleber sozusagen verkeilt.

In der Zeichnung ist ein Ausführungsbeispiel des Gegenstandes nach der Erfindung dargestellt, das auch das erfindungsgemäße Verfahren stufenweise wiedergibt. Es zeigt:
Figur 1 einen Gehäusedeckel in teils geschnittener Ansicht,
Figur 2 den Gehäusedeckel nach Figur 1 in Unteransicht,
Figur 3 in geschnittener Ansicht den Gehäusedeckel nach Figur 1 mit aufgetragenem Schmelzkleber,
Figur 4 Gehäusebecher, Gehäusedeckel und ein OF W-Filter in montiertem Zustand und geschnittener Ansicht,
Figur 5 das Gehäusebecherinnere in Draufsicht,
Figur 6 das OF W-Filter samt Gehäuse nach dem Aufheizen des Schmelzklebers auf Schmelztemperatur und in geschnittener Ansicht,
Figur 7 in der Darstellung nach Figur 6 das fertigmontierte, vergoßene OF W-Filter samt Gehäuse.

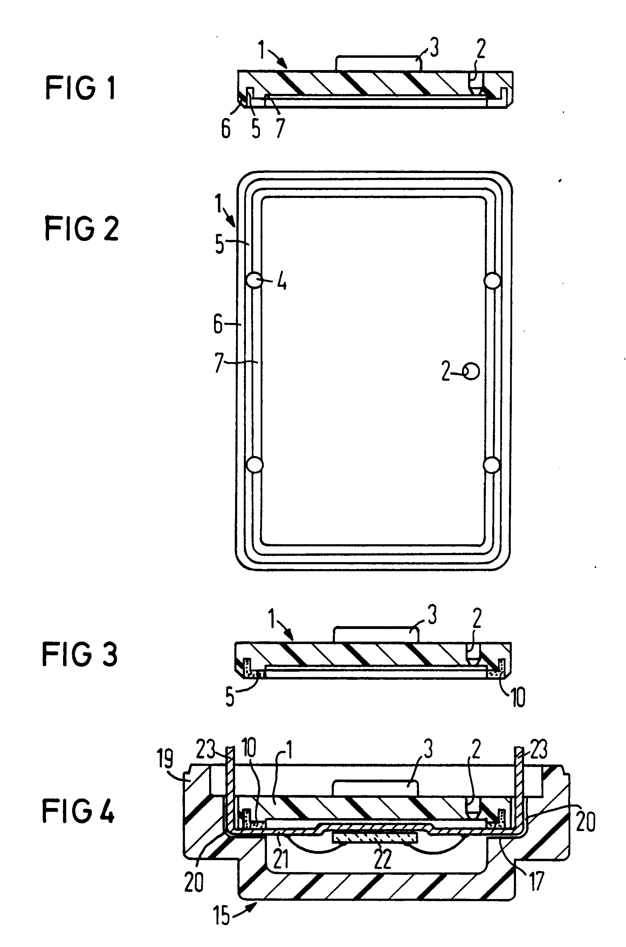

Der Deckel 1 nach Figur 1 bis 3 besitzt einen Zentrierknopf 3, der beim Verguß als Füllstandanzeige und zum Greifen und/oder Zentrieren des Gehäusedeckels 1 während der automatischen Montage dient. Die vom Zentrierknopf 3 abgekehrte Seitenfläche des Gehäusedeckels 1 ist abgestuft, derart daß Stege 6,7 im Randbereich eine umlaufende Rinne 5 bilden, die zunächst, d. h. zu Beginn der Montage, zusammen mit der Oberfläche des Steges 7 einen Schmelzkleber 10 trägt.

Die Haftung des Schmelzklebers 10, der mit verhältnismäßig geringer Temperatur auf den Gehäusedeckel 1 aufgespritzt wird, ist durch Bohrungen 4 erhöht, in denen sich der aufgespritzte Schmelzkleber dübelartig festkrallt.

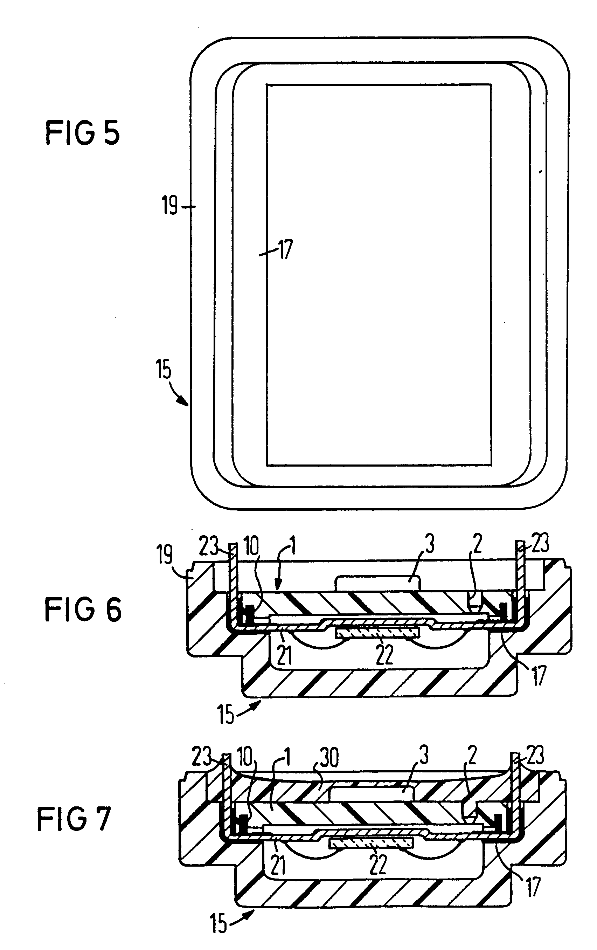

Der gemäß Figur 3 mit Schmelzkleber 10 beschichtete Gehäusedeckel 1 wird anschließend in einen Gehäusebecher 15 - siehe Figur 4,5 - eingesetzt, auf dessen Auflageschultern 17 bereits eine Trägerspinne 21 für ein OFW- Filter 22 aufliegt, die rechtwinklig nach außen gebogene Anschlußelemente 23 aufweist. Im Bereich 19 über der Gehäusedeckel - Außenfläche ist die Innenwandung des Gehäusebecherrandes in Bezug auf die Anschlußelemente 23 nach außen versetzt.

Wie aus Figur 4 bis 7 erkennbar ist, bilden die im Durchführungsbereich der Anschlußelemente 23 zueinander gekehrten Rand- und gegebenenfalls Stirnflächen des Gehäusedeckels 1 und Gehäusebechers 15 einen Spalt 20, der sich beim Aufheizen des Schmelzklebers 10, was bevorzugt im Vakuum erfolgt, mit Schmelzkleber vollsaugt. Hierdurch wird der Spalt 20 zwischen Gehäusedeckel 1 und Gehäusebecher 15 abgedichtet. Eine Ent- .lüftungsbohrung 2 im Gehäusedeckel 1, die erst beim abschließenden Verguß geschlossen wird, verhindert schließlich den Einschluß von Luftblasen im Becherinneren. Als Vergußmasse dient bevorzugt Epoxidharz 30, das - siehe Figur 7 - auf die nach außen gekehrte Spalt- und Gehäusedeckelfläche aufgetragen und ausgehärtet wird.

Bereits durch den Schmelzkleber 10 wird ein ausgezeichneter Verschluß des Gehäuseinneren geschaffen, der in Verbindung mit dem Epoxidharzverguß 30 bei hoher termischer Belastung, z. B. der Anschlußelemente, einen sicheren hermetischen Abschluß des Gehäuses gewährleistet.

## Patentansprüche

1. Gehäuse mit durch einen Gehäusedeckel (1) geschlossenem Gehäusebecher (15) zur Aufnahme elektrischer Bauelemente, Bauelementegruppen oder integrierter Schaltungen, insbesondere von Oberflächenwellenfiltern, deren elektrische und gegebenenfalls mechanische Anschlußelemente durch den zwischen den zueinander gekehrten Randflächen des Gehäusebechers und Gehäusedeckels gebildeten Spalt (20) herausgeführt sind, wobei der Spalt (20) mittels Kunstharzvergußmasse (30) und zumindest in den Bereichen der Anschlußelemente (23) zusätzlich mittels Schmelzkleber (10) im Spalt (20) geschlossen ist.

2. Gehäuse nach Anspruch 1 **dadurch gekennzeichnet,** daß der Schmelzkleber (10) sich über die gesamte Länge des Spalts (20) erstreckt.

3. Gehäuse nach Anspruch 1 und 2 **dadurch gekennzeichnet,** daß der gesamte Spalt (20) mit Schmelzkleber (10) ausgefüllt und die nach außen gekehrte Spalt- und bevorzugt die gesamte äußere Gehäusedeckelfläche mit Vergußmasse (30) bedeckt ist.

4. Verfahren zum hermetisch dichten Verschluß eines Gehäusebechers mit einem Gehäusedeckel gemäß Patentanspruch 1, wobei zumindest die zu den Anschlußelementen (23) gekehrte, spaltbildende Fläche des Gehäusedeckels und/oder Gehäusebechers (1 bzw. 15) mit Schmelzkleber (10) bedeckt, der Gehäusedeckel (1) in den Gehäusebecher (15) eingesetzt und anschließend der Schmelzkleber (10) geschmolzen wird, wonach Vergußmasse (30) auf die nach außen gekehrte Spalt- und Gehäusedeckelfläche aufgetragen und ausgehärtet wird.

5. Verfahren nach Anspruch 4 **dadurch gekennzeichnet,** daß der Schmelzkleber (10) im Vakuum geschmolzen wird.

6. Verfahren nach Anspruch 4 **dadurch gekennzeichnet,** daß ein Gehäusedeckel (1) mit beim Schmelzen des Schmelzklebers (10) zunächst offener Entlüftungsbohrung (2) verwendet wird, die beim abschließenden Verguß geschlossen wird.

7. Verfahren nach Anspruch 4 **dadurch gekennzeichnet,** daß der Schmelzkleber (10) auf die zum Gehäusebecher (15) gekehrte, abgestufte Randfläche (5,7) des Gehäusedeckels (1) auf - und in im Bereich der Randfläche (5,7) angeordnete Bohrungen (4) eingespritzt wird.

## Claims

1. Casing having a casing can (15), closed by a casing cover (1), for receiving electric components, component packages or integrated circuits, in particular of surface-wave filters, the electrical and, if appropriate, mechanical connection elements of which are brought out through the gap (20) formed between the mutually facing edge surfaces of the casing can and casing cover, the gap (20) being closed by means of a synthetic resin casting compound (30) and, at least in the regions of the connection elements (23), additionally by means of hot-melt adhesive (10) in the gap (20).

2. Casing according to Claim 1, characterised in that the hot-melt adhesive (10) extends over the entire length of the gap (20).

3. Casing according to Claims 1 and 2, characterised in that the entire gap (20) is filled with hot-melt adhesive (10) and the outwardly facing gap surface, and preferably the entire outer casing cover surface, is covered with casting compound (30).

4. Process for the hermetically tight closure of a casing can having a casing cover according to Patent Claim 1, at least the gap-forming surface of the casing cover and/or casing can (1 and 15, respectively) facing the connection elements (23) being covered with hot-melt adhesive (10), the casing cover (1) being fitted into the casing can (15) and the hot-melt adhesive (10) subsequently melted, after which casting compound (30) is applied to the outwardly facing gap and casing cover surface and is cured.

5. Process according to Claim 4, characterised in that the hot-melt adhesive (10) is melted in a vacuum.

6. Process according to Claim 4, characterised in that a casing cover (1) having a venting bore (2) which is initially open during melting of the hot-melt adhesive (10) and is closed during the concluding casting is used.

7. Process according to Claim 4, characterised in that the hot-melt adhesive (10) is sprayed onto the stepped edge surface (5, 7) of the casing cover (1) facing the casing can (15) and is sprayed into the bores (4) arranged in the region of the edge surface (5, 7).

## Revendications

1. Boîtier comportant un pot (15) fermé par un couvercle (1) du boîtier et servant à loger des composants électriques, des groupes de composants ou des circuits intégrés, notamment des filtres à ondes de surface, dont les éléments de raccordement électrique et éventuellement mécanique passent à travers la fente (20) formée entre les surfaces marginales, qui se font face, du pot et du couvercle du boîtier, la fente (20) étant fermée par une masse de scellement en matière plastique (30) et, en supplément, et au moins dans les zones des éléments de raccordement (23), par une colle fusible (10) dans la fente (20).

2. Boîtier suivant la revendication 1, caractérisé par le fait que la colle fusible (10) s'étend sur toute la longueur de la fente (20).

3. Boîtier suivant les revendications 1 et 2, caractérisé par le fait que l'ensemble de la fente (20) est rempli par une colle fusible (10) et que la fente tournée vers l'extérieur et de préférence l'ensemble de la surface extérieure du couvercle du boîtier sont fermés par une masse de scellement (30).

4. Procédé pour fermer d'une manière hermétique un pot de boîtier comportant un couvercle suivant la revendication 1, selon lequel on recouvre au moins la surface du couvercle du boîtier et/ou du pot du boîtier (1 ou 15), qui forme la fente et est tourné vers les éléments de raccordement (23), par une colle fusible (10), qu'on introduit le couvercle (1) du boîtier dans le pot (15) du boîtier et qu'on fait fondre ensuite la colle fusible (10), à la suite de quoi on dépose une masse de scellement (30) sur la surface de la fente et la surface du couvercle du boîtier, tournées vers l'extérieur, et qu'on la fait durcir.

5. Procédé suivant la revendication 4, caractérisé par le fait qu'on fait fondre la colle fusible (10) sous vide.

6. Procédé suivant la revendication 4, caractérisé par le fait qu'on utilise un couvercle (1) du boîtier pourvu d'un perçage de désaération (2), qui est tout d'abord ouvert lors de la fusion de la colle fusible (10) et est fermé lors du scellement final.

7. Procédé suivant la revendication 4, caractérisé par le fait que la colle fusible (10) est projetée sur la zone marginale étagée (5,7) du couvercle (1) du boîtier, tournée vers le pot (15) du boîtier - et est injectée dans des perçages (4) disposés dans la zone de la surface marginale (5,7).
